(19) Europäisches Patentamt / European Patent Office / Office européen des brevets

(11) **EP 2 017 929 A2**

(12) **EUROPEAN PATENT APPLICATION**

(43) Date of publication:
**21.01.2009 Bulletin 2009/04**

(51) Int Cl.:
***H01S 5/14*** *(2006.01)*

(21) Application number: **08011376.4**

(22) Date of filing: **23.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **18.07.2007 JP 2007186400**

(71) Applicant: **Yokogawa Electric Corporation Tokyo 180-8750 (JP)**

(72) Inventors:
  • **Ito, Akishige**
   **Musashino-shi**
   **Tokyo 180-8750 (JP)**

• **Asami, Keisue**
 **Musashino-shi**
 **Tokyo 180-8750 (JP)**
• **Suzuki, Yasuyuki**
 **Musashino-shi**
 **Tokyo 180-8750 (JP)**

(74) Representative: **Grünecker, Kinkeldey, Stockmair & Schwanhäusser Anwaltssozietät Leopoldstrasse 4 80802 München (DE)**

(54) **Wavelength tunable light source of external resonator type**

(57)    An improvement is made to a wavelength tunable light source of an external resonator type for selecting a wavelength of light from a semiconductor laser (1) using a diffraction grating (3). The device has a prism (6,7,8) provided between the semiconductor laser (1) and the diffraction grating (3) for enlarging the beam shape of the light from the semiconductor laser (1) in the groove arrangement direction of the diffraction grating (3), emitting the light to the diffraction grating, and reflecting diffracted light from the diffraction grating to provide output light.

## FIG. 1

ZERO-ORDER LIGHT

OUTPUT LIGHT

**Description**

This application claims priority to Japanese Patent Application No. 2007-186400, filed July 18, 2007, in the Japanese Patent Office. The Japanese Patent Application No. 2007-186400 is incorporated by reference in its entirety.

TECHNICAL FIELD

The present disclosure relates to a wavelength tunable light source of an external resonator type for selecting a wavelength of light from a semiconductor laser using a diffraction grating (for example, Littrow mounting, Littman mounting, etc.,). More particularly, the present disclosure relates to a wavelength tunable light source of an external resonator type for improving wavelength selectivity and efficiently outputting output light.

RELATED ART

A wavelength tunable light source of an external resonator type executes wavelength dispersion and wavelength selection of light from a semiconductor laser with a diffraction grating and feeds the light whose wavelength is selected into the semiconductor laser for lasing at any desired wavelength. The wavelength tunable light source of the external resonator type includes a wavelength tunable light source of Littrow mounting, a wavelength tunable light source of Littman mounting, etc., for example.

A far field pattern of light emitted from a semiconductor laser is an elliptical collimated light beam and is a beam shape short relative to the groove arrangement direction of a diffraction grating (wavelength dispersion direction, hereinafter called horizontal direction) and long relative to the groove direction.

On the other hand, the larger the light irradiation width in the horizontal direction of the diffraction grating (the larger the number of grooves irradiated with light), the larger the wavelength dispersion of the diffraction grating and the higher the wavelength selectivity. Then, the beam shape of light emitted from the semiconductor laser is shaped from an ellipse to a circle for improving the wavelength selectivity of the diffraction grating.

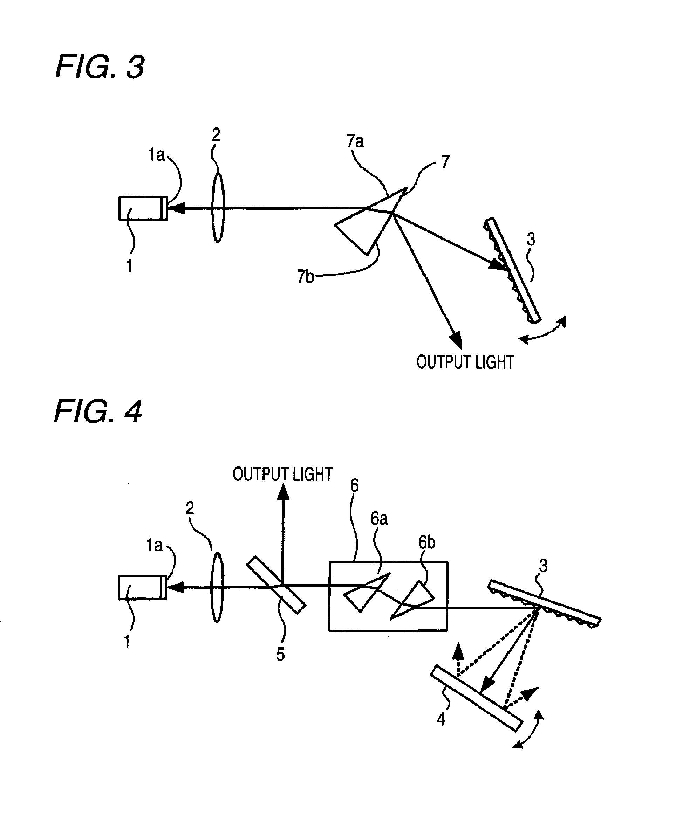

FIG. 4 is a drawing to show the configuration of a wavelength tunable light source of an external resonator type in a related art. (For example, refer to patent document 1.) In FIG. 4, a semiconductor laser 1 has one end face 1a subjected to antireflection treatment (for example, AR coating) and emits light from the end face 1a subjected to the AR coating.

A lens 2 converts light from the semiconductor laser 1 into a collimated light beam for emission and collects fed-back light (hereinafter, also called return light) on the end face 1a of the semiconductor laser 1 subjected to the AR coating.

A diffraction grating 3 executes wavelength dispersion of the light from the lens 2 for emission to a mirror 4 and again executes wavelength dispersion of the reflected light from the mirror 4 for emission to the lens 2.

The mirror 4 selects light of any desired wavelength of diffracted light subjected to the wavelength dispersion in the diffraction grating 3 and reflects the selected light on the diffraction grating 3. The mirror 4 rotates on a predetermined point so as to form Littman mounting.

A beam splitter 5 is provided between the lens 2 and the diffraction grating 3, branches one part of the return light from the diffraction grating 3 for output as output light, and feeds back the other part into the semiconductor laser 1 through the lens 2.

A beam expander 6 has an anamorphic prism pair (anamorphic prisms 6a and 6b), is provided between the beam splitter 5 and the diffraction grating 3, and shapes the beam shape of the light from the semiconductor laser 1 to a circle for emission to the diffraction grating 3.

The operation of the device is as follows:

Light emitted from the one end face 1a of the semiconductor laser 1 is converted into a collimated light beam through the lens 2 and the collimated light beam passes through the beam splitter 5 and is shaped by the beam expander 6 (the beam shape is expanded in the horizontal direction). Wavelength dispersion of the shaped light beam is executed by the diffraction grating 3 for emission to the mirror 4. Only light of any desired wavelength is reflected on the mirror 4 toward the diffraction grating 3, which then again executes wavelength selection of the reflected light.

The light subjected to the wavelength selection twice is fed back into the semiconductor laser 1 through the beam expander 6, the beam splitter 5, and the lens 2 and an opposite end face of the semiconductor laser 1 and the mirror 4 form an external resonator for lasing. The mirror 4 is rotated, whereby the resonator length and the reflection wavelength also change and stable single-mode oscillation is executed at any desired wavelength.

Further, the beam splitter 5 branches the light fed back into the semiconductor laser 1 (namely, return light subjected to wavelength selection twice) and outputs a part as output light. Accordingly, laser light extremely high in simplex from which spontaneous emission light generated in the semiconductor laser 1 is removed is output as output light.

[Patent document 1] Japanese Patent Laid-Open No. 198881/1993

Thus, the beam expander 6 is provided between the semiconductor laser 1 and the diffraction grating 3, so that the irradiation width of the diffraction grating in the horizontal direction is improved and the wavelength selectivity becomes high. The beam splitter 5 is provided between the semiconductor laser 1 and the diffraction grating 3, so that spontaneous emission light generated in the semiconductor laser 1 can be removed and output light extremely high in simplex can be provided.

However, the beam splitter 5 and the anamorphic prisms 6a and 6b of the beam expander 6 are each a refraction medium having a larger refraction index than air (glass, etc.). Thus, the refraction media 5, 6a, and 6b are provided in the optical path, so that the external resonator length increases, the mode spacing becomes narrow, and the wavelength selectivity worsens; this is a problem.

Since the number of components on the optical path in the external resonator increases, the loss of light power in the external resonator grows and the efficiency of the light power is impaired; this is also a problem.

SUMMARY

Exemplary embodiments of the present invention provide a wavelength tunable light source of an external resonator type for improving wavelength selectivity and efficiently outputting output light.

The invention according to a first aspect provides a wavelength tunable light source of an external resonator type for selecting a wavelength of light from a semiconductor laser using a diffraction grating, characterized by a prism being provided between the semiconductor laser and the diffraction grating for enlarging the beam shape of the light from the semiconductor laser in the groove arrangement direction of the diffraction grating, emitting the light to the diffraction grating, and reflecting diffracted light from the diffraction grating to provide output light.

The invention according to the second aspect is characterized by the fact that in the invention according to the first aspect, a mirror for reflecting the diffracted light from the diffraction grating to the diffraction grating is provided, and the prism outputs the output light from between the diffraction grating and the mirror.

The invention according to the third aspect is characterized by the fact that in the invention according to the second aspect, the prism outputs the output light roughly in parallel with zero-order light of the diffraction grating.

The invention according to the fourth aspect is characterized by the fact that in the invention according to the first aspect, the prism lessens the incidence angle on the diffraction grating with a temperature rise.

The invention according to the fifth aspect is characterized by the fact that in the invention according to any of the first to fourth aspects, the light from the semiconductor laser is incident on the prism at Brewster angle.

The invention according to the sixth aspect is characterized by the fact that in the invention according to any of the first to fifth aspects, the prism is an anamorphic prism.

The invention provides the following advantages:

The single prism provided between the semiconductor laser and the diffraction grating (on the optical path in the external resonator) performs the beam shaping of the light from the semiconductor laser and reflects a part of the diffracted light from the diffraction grating to provide output light, so that the number of the components of the refraction media in the external resonator can be decreased. Accordingly, an increase in the external resonator length can be lessened, narrowing the mode spacing can be suppressed, and the wavelength selectivity can be enhanced. Further, as the number of the components of the refraction media is decreased, the loss of light power can be suppressed. Therefore, the wavelength selectivity can be improved and the output light can be efficiently output.

Other features and advantages may be apparent from the following detailed description, the accompanying drawings and the claims.

BRIEF DESCRIPTION OF THE DRAWINGS

In the accompanying drawings:

FIG. 1 is a configuration drawing to show a first embodiment of the invention;
FIG. 2 is a configuration drawing to show a second embodiment of the invention;
FIG. 3 is a configuration drawing to show a third embodiment of the invention; and
FIG. 4 is a drawing to show the configuration of a wavelength tunable light source of an external resonator type in a related art.

DETAILED DESCRIPTION

An embodiment of the invention will be discussed with the accompanying drawing.

[First embodiment]

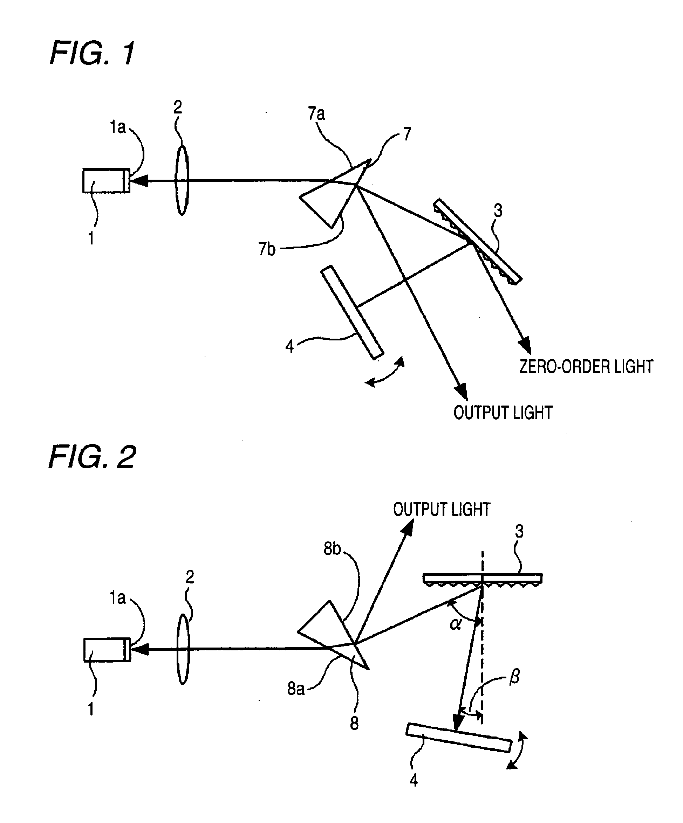

FIG. 1 is a configuration drawing to show a first embodiment of the invention. Components identical with those in FIG. 4 are denoted by the same reference numerals in FIG. 1 and will not be discussed again. In FIG. 1, a prism 7 is provided in place of the beam splitter 5 and the beam expander 6 in FIG. 4.
The prism 7 is a simple anamorphic prism roughly shaped like a wedge and is provided on an optical path of a lens 2 and a diffraction grating 3. The refraction index of the prism 7 is higher than that of air; for example, refraction index 1. 6 or more is preferred. The prism 7 is glass (crown glass, flint glass, etc.,) a synthetic resin, etc., for example.
The plane of the prism 7 on which light from a semiconductor laser 1 is incident is an incidence plane 7a and the plane for emitting incidence light from the incidence plane 7a to the diffraction grating 3 (namely, the plane on which return light from the diffraction grating 3 is incident) is an outgoing plane 7b.
The incidence plane 7a is coated with an antireflection film (for example, AR coating) and the outgoing plane 7b is not coated with an antireflection film or a partial reflection film having any desired reflection factor. If the incidence angle of light incident on the incidence plane 7a from the semiconductor laser 1 is set to Brewster angle, the incidence plane 7a need not be coated with an antireflection film. That is, light from the semiconductor laser 1 is direct polarization and thus the incidence light on the incidence plane 7a from the semiconductor laser 1 is not reflected on the incidence plane 7a and is fully passed through the incidence plane 7a.
The semiconductor laser 1, the diffraction grating 3, a mirror 4, and the like are disposed so as to form Littman mounting. Since refraction media of the prism 7, the lens 2, etc., exist in an external resonator, the reference position of rotation of the mirror 4 differs from the position in the case where the refraction media do not exist, of course.
The operation of the device is as follows:
Light emitted from one end face (nonreflection end) 1a of the semiconductor laser 1 is converted into a collimated light beam through the lens 2 and the collimated light beam is incident on the prism 7. At this time, the collimated light beam from the lens 2 is incident on the prism 7 without being reflected on the incidence plane 7a of the prism 7.
The collimated light beam is shaped through the prism 7 (the beam shape is expanded in the horizontal direction) and is emitted from the outgoing plane 7b to the diffraction grating 3. Further, first wavelength dispersion of the shaped light beam is executed by the diffraction grating 3 for emission to the mirror 4. Only light of any desired wavelength is selected on the mirror 4 and is reflected toward the diffraction grating 3, which then again executes wavelength dispersion of the reflected light and wavelength selection for emission to the prism 7.
The light subjected to the wavelength selection twice is incident on the outgoing plane 7b of the prism 7. At this time, partial return light is reflected on the outgoing plane 7b because of the refractive index difference between the prism 7 and air and most return light is incident on the prism 7 without being reflected on the outgoing plane 7b.
The return light incident on the prism 7 is emitted from the incidence plane 7a and is fed back into the semiconductor laser 1 through the lens 2 and an opposite end face of the semiconductor laser 1 and the mirror 4 form an external resonator for lasing. The mirror 4 is rotated, whereby the resonator length and the reflection wavelength also change and stable single-mode oscillation is executed at any desired wavelength.
On the other hand, the light reflected on the outgoing plane 7b of the prism 7, of the return light from the diffraction grating 3 is taken out as output light and is output. At this time, it is advisable to set the outgoing plane 7b of the prism 7 so that the output light is output roughly in parallel with zero-order light in the diffraction grating 3 (the optical axis of the zero-order light and the optical axis of the reflected light on the prism 7 are parallel). There are two types of zero-order light of the diffraction grating 3, namely, zero-order light based on the light incident on the diffraction grating 3 from the prism 7 and zero-order light based on the reflected light on the mirror 4. Here, the zero-order light is based on the light incident on the diffraction grating 3 from the prism 7.
Thus, the single prism 7 provided between the semiconductor laser 1 and the diffraction grating 3 serves as both shaping of collimated light beam and taking out of output light from the second diffracted light, so that the number of the components of the refraction media in the external resonator can be decreased as compared with the device shown in FIG. 4. Accordingly, an increase in the external resonator length can be lessened, narrowing the mode spacing can be suppressed, and the wavelength selectivity can be enhanced. Further, as the number of the components of the refraction media is decreased, the loss of light power can be suppressed.
Therefore, the wavelength selectivity can be improved and the output light can be efficiently output.
Since the number of the components can be decreased as compared with the device shown in FIG. 4, cost reduction and miniaturization can be accomplished. Further, parallel plane portions among the portions are eliminated and the effects of interference and stray light caused by multiple reflection can be suppressed.
Only the incidence plane 7a of the prism 7 is coated with an antireflection film, so that the manufacturing cost of the prism 7 can be suppressed. If the incidence angle of light incident on the incidence plane 7a is set to Brewster angle, the incidence plane 7a need not be coated with an antireflection film, so that the manufacturing cost of the prism 7 can be further suppressed.
A part of the light fed back into the semiconductor laser 1 (namely, the return light subjected to the wavelength selection twice) is reflected on the outgoing plane 7b of the prism 7 to provide output light, so that laser light extremely high in simplex from which spontaneous emission light generated in the semiconductor laser 1 is removed can be output as output light.

For example, to also use zero-order light of the diffraction grating 3 as output light for monitor of light power of the wavelength tunable light source, etc., the prism 7 outputs the reflected light on the outgoing plane 7b roughly in parallel with the zero-order light of the diffraction grating 3, so that coupling with an optical fiber (not shown) is facilitated and simplification and miniaturization of the structure can be accomplished.

An embodiment of the invention will be discussed with the accompanying drawing.

[Second embodiment]

FIG. 2 is a configuration drawing to show a second embodiment of the invention; it shows an embodiment for suppressing fluctuation of the selected wavelength if an ambient temperature fluctuates. Components identical with those in FIG. 1 are denoted by the same reference numerals in FIG. 2 and will not be discussed again.

In FIG. 2, a prism 8 with the orientation of the prism 7 made opposite is provided in place of the prism 7 in FIG. 1. That is, in FIG. 1, the vertical angle formed by the incidence plane 7a and the outgoing plane 7b of the prism 7 is on the side of the diffraction grating 3 with respect to the optical axis; whereas, in FIG. 2, the vertical angle formed by an incidence plane 8a and an outgoing plane 8b of the prism 8 is provided on the side of a mirror 4.

The operation of the device is as follows:
The device is almost similar to the device shown in FIG. 1 in that a semiconductor laser 1 and the mirror 4 form an external resonator for lasing and that beam shaping is performed through the prism 8. The difference between the devices will be discussed below:

A part of return light from a diffraction grating 3 is reflected on the outgoing plane 8b of the prism 8 to provide output light. The reflection direction on the outgoing plane 8b (output direction of output light) is the direction of the back of the diffraction grating 3 rather than the direction between the diffraction grating 3 and the mirror 4.

Subsequently, the case where an ambient temperature fluctuates will be discussed.
The relation of wavelength dispersion of light incident on the diffraction grating 3 is represented by the following expression (1):

$$\mathrm{Sin}\alpha \pm \mathrm{Sin}\beta = N \bullet m \bullet \lambda \qquad (1)$$

The parameters are as follows:

α: Incidence angle on diffraction grating 3 from prism 8
β: Outgoing angle from diffraction grating 3
N: Number of slits per mm (namely, number of grooves of diffraction grating 3 and reciprocal of diffraction grating period)
m: Order of diffracted light (m = 0, ±1, ±2, ±3...)
X: Wavelength

For example, if the ambient temperature becomes high, the diffraction grating 3 expands and the groove pitch of the diffraction grating 3 widens. Thus, if the positional relationship between the diffraction grating 3 and the mirror 4 does not fluctuate, the wavelength selected with the diffraction grating 3 and the mirror 4 shifts to the long wavelength side.

On the other hand, as the ambient temperature rises, the refractive index of the prism 8 increases and the refraction angle also increases. Thus, the incidence angle α on the diffraction grating 3 from the prism 8 lessens. Thus, if the positional relationship between the diffraction grating 3 and the mirror 4 does not fluctuate, the wavelength selected with the diffraction grating 3 and the mirror 4 shifts to the short wavelength side.

That is, the prism 8 lessens the incidence angle α on the diffraction grating 3 with a rise in the temperature, so that the wavelength shift caused by expansion of the groove pitch of the diffraction grating 3 can be compensated for. Accordingly, if the ambient temperature fluctuates, the fluctuation of the selected wavelength can be suppressed.

The invention is not limited to the embodiments described above and may be the following:

(1) Although the outgoing plane 7b of the prism 7 is not provided with an antireflection film or a partial reflection film, the percentage of reflecting return light by the outgoing plane 7b of the prism 7 is affected by the refractive index difference between the prism 7 and air, the incidence angle of return light on the outgoing plane 7b, etc.

Therefore, to increase or decrease the percentage of taking out the output light through the prism 7, the material of the prism 7 or the incidence angle may be changed. For example, to increase the percentage of taking out the output light (to provide higher output light), the refractive index of the prism 7 is increased (for example, to 1.6 or more). To take out large output light, the outgoing plane 7b may be coated with a partial reflection film.

(2) Although the configuration of the wavelength tunable light source of the external resonator type of the Littman mounting has been shown, the invention may be applied to any wavelength tunable light source of an external resonator type for executing wavelength selection using the diffraction grating 3. FIG. 3 is a configuration drawing to show an example of applying the invention to Littrow mounting. Components identical with those in FIG. 1 are denoted by the same reference numerals in FIG. 3 and will not be discussed again. In FIG. 3, the mirror 4 in FIG. 1 is removed and a diffraction grating 3 rotates and moves. The incidence angle on the diffraction grating 3 is set so that light of any desired wavelength, of diffracted light of the diffraction grating 3 is fed back into a semiconductor laser 1.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

**Claims**

1. A wavelength tunable light source of an external resonator type comprises:

   a semiconductor laser for emitting a light;
   a diffraction grating for selecting a wavelength of the light from the semiconductor laser; and
   a prism being provided between the semiconductor laser and the diffraction grating for enlarging a beam shape of the light from the semiconductor laser in a groove arrangement direction of the diffraction grating, emitting the light to the diffraction grating, and reflecting a diffracted light from the diffraction grating to provide an output light.

2. The wavelength tunable light source of the external resonator type as claimed in claim 1 further comprising:

   a mirror for reflecting the diffracted light from the diffraction grating to the diffraction grating,

   wherein said prism outputs the output light from between the diffraction grating and the mirror.

3. The wavelength tunable light source of the external resonator type as claimed in claim 2 wherein said prism outputs the output light roughly in parallel with zero-order light of the diffraction grating.

4. The wavelength tunable light source of the external resonator type as claimed in claim 1 wherein said prism lessens the incidence angle on the diffraction grating with a temperature rise.

5. The wavelength tunable light source of the external resonator type as claimed in any of claims 1 to 4 wherein the light from the semiconductor laser is incident on said prism at Brewster angle.

6. The wavelength tunable light source of the external resonator type as claimed in any of claims 1 to 5 wherein said prism is an anamorphic prism.

7. The wavelength tunable light source of the external resonator type as claimed in claim 1 wherein an incidence plane of the prism on which the light from the semiconductor laser is incident is coated with an antireflection film.

8. The wavelength tunable light source of the external resonator type as claimed in claim 1 wherein an outgoing plane of the prism from which the light is emitted to the diffraction grating is coated with a partial reflection film.

## FIG. 1

ZERO-ORDER LIGHT

OUTPUT LIGHT

## FIG. 2

OUTPUT LIGHT

## FIG. 3

OUTPUT LIGHT

## FIG. 4

OUTPUT LIGHT

**REFERENCES CITED IN THE DESCRIPTION**

**Patent documents cited in the description**

- JP 2007186400 A

- JP 5198881 A